# EUROPEAN PATENT APPLICATION

(11) **EP 0 561 079 A1**
(43) Date of publication of application: **22.09.1993**
(21) Application number: 92310697.5
(22) Date of filing: 23.11.1992
(51) Int. Cl.: G03F 7/023, G11B 7/24, G11B 7/26

(54) **Photoresist for optical disc and method of preparing optical disc utilizing photoresist**

(30) Priority: 16.03.1992 JP 58051/92
(71) Applicant: PIONEER ELECTRONIC CORPORATION, Meguro-ku Tokyo-to (JP)
(72) Inventor: Iida, Tetsuya, c/o Pioneer Electronic Corp., Tsurugashima-shi, Saitama-ken (JP); Higuchi, Takanobuo,c/o Pioneer Electronic Corp., Tsurugashima-shi, Saitama-ken (JP); Sasaki, Hironaoc/o Pioneer Electronic Corp., Tsurugashima-shi, Saitama-ken (JP); Ogoshi, Kunizo,c/o Pioneer Electronic Corp., Tsurugashima-shi, Saitama-ken (JP)
(74) Representative: Brunner, Michael John

(57) **Abstract**

A photoresist adapted for manufacture of an optical disc original comprises a photosensitive material and a base resin, in which a molecular weight distribution (weight average molecular weight M_{w} / number average molecular weight Mₙ) in the base resin has a value less than 5.8, preferably less than 5.0. The photosensitive agent has an esterification ratio of more than 80% and preferably more than 90%. The base resin is composed of a cresol novolak resin and the photosensitive agent is a reactant formed by reacting a 1,2-naphthoquinonediazido-5-sulfonylchloride to a nonbenzophenon series ballast compound having 30 to 40 weight parts with respect to the cresol novolak resin of 100 weight parts. An optical disc is prepared by the steps of coating a positive-type photoresist on a glass substrate (100) to form a resist film, forming a pit pattern through a light exposure to the resist film, developing the resist film after the light exposure to form a resist original, effecting a plating treatment to the resist original to form a stamper(104) by an electrocasting treatment, forming a replica disc through an injection molding process by utilizing the stamper (104), forming a reflection film on the replica disc, and forming an overcoat layer on the reflection film.

## Description

This invention relates to a photoresist for an optical disc particularly capable of being preferably utilized for manufacturing an optical disc having high recording density and also relates to a method of preparing an optical disc utilizing the photoresist.

In a conventional art, an optical disc is generally manufactured in accordance with the following steps.

First, a positive-type photoresist is coated with uniform thickness on a glass substrate which was ground finely to thereby form a photoresist layer. In the next step, a laser beam is irradiated to a portion of the photoresist layer at which a pit is formed. A portion of the photoresist layer irradiated to the laser beam is easily dissolved in an alkali liquid developer in comparison with another portion not irradiated. Accordingly, when the development is performed by coating the alkali liquid developer on the photoresist layer, a recess corresponding to a pit is formed to the portion irradiated to the laser beam. Thereafter, a metallic film is formed on the photo-resist layer to which an electroconductivity is imparted, and in this step, For example, silver (Ag) or nickel(Ni) may be utilized as a metal for forming the metallic film. In the next step, an electrocasting treatment is performed to form an electrocast product, Ni electrocast, for example, on the metallic film. The nickel electrocast is then peeled off from the glass substrate and the photoresist layer together with the metallic film, the thus peeled off nickel electrocast and metallic film being called a metallic original, i.e. stamper.

In such optical disc original manufacturing steps, a photoresist for manufacturing a semiconductor is utilized as it is in the conventional art.

However, in recent studies and experiments of the inventors of the subject application for achieving high density of an optical disc, it was found that the conventional photoresist for manufacturing a semiconductor is not suitable for the manufacturing of the optical disc having high recording density.

Namely, in a case where an optical disc original having high density with small pit size is manufactured by utilizing a conventional photoresist for manufacturing a semiconductor and the optical disc is formed from this optical disc original, a noise level increases at a reproduction time in accordance with the reduction of the pit size and, hence, a sufficient CN ratio (carrier-wave/noise ratio), this providing a significant problem.

An object of this invention is to substantially eliminate the defects or drawbacks encountered in the prior art described above and to provide a photoresist for an optical disc and a method of preparing an optical disc utilizing the photoresist, capable of obtaining an optical disc having improved high recording density in which pit shapes are not uneven in making small the pit size, and hence, having the low noise level at a reproduction time and the improved CN ratio.

This and other objects can be achieved according to this invention by providing a positive-type photoresist adapted for manufacture of an optical disc original comprising a photosensitive agent and a base resin, in which a molecular weight distribution (weight average molecular weight M_{w} / number average molecular weight Mₙ ) in the base resin has a value less than 5.8.

There is also provided a method of preparing an optical disc comprising the steps of:
preparing a positive-type photoresist composed of a base resin and a photosensitive material and also preparing a glass substrate;
coating the photoresist on the glass substrate to form a resist film;
forming a pit pattern through a light exposure to the resist film;
developing the resist film after the light exposure to form a resist original;
effecting a plating treatment to the resist original to form a stamper;
forming a replica disc through an injection molding process by utilizing the stamper;
forming a reflection film on the replica disc; and
forming an overcoat layer on the reflection film,
wherein the positive-type photoresist satisfies a condition that a molecular weight distribution (weight average molecular weight M_{w} / number average molecular weight Mₙ) in the base resin has a value less than 5.8.

In a preferred embodiment, the molecular weight distribution has a value less than 5.0. The photosensitive agent has an esterification ratio of more than 80% and preferably more than 90%. The base resin is composed of a cresol novolak resin and the photosensitive agent is a reactant formed by reacting a 1,2-naphthoquinonediazido-5-sulfonylchloride to a nonbenzophenon series ballast compound having 30 to 40 weight parts with respect to the cresol novolak resin of 100 weight parts.

According to the photoresist of the character described above, the exposure and developing reactions can uniformly progress in the resist film and the pits are evenly formed even in the small pit size. Accordingly, when an optical disc with high recording density having small pit size is manufactured by utilizing this photoresist, the noise level can be made small in the reproduction time, and the improved CN ratio can be achieved.

The component of the photoresist of the optical disc of the character described above will be mentioned hereunder.

The photoresist includes a base resin and a photosensitive agent. An alkali fusible novolak resin is preferably utilized as the base resin, for example, and more preferably, cresol novolak or phenol novolak resin will be utilized.

A molecular weight distribution (weight average molecular weight M_{w} / number average molecular weight Mₙ) is less than 5.8 and, preferably, the molecular weight distribution M_{w}/ Mₙ is a value less than 5.0. when the value exceeds the value of 5.8, the exposure and the development cannot progress evenly in a photoresist film formed by using a photoresist containing the base resin having the weight molecular distribution of a value more than 5.8, and particularly, when the pits are formed with a small size, the shapes of these pits are not uniformly formed, which results in high noise level of the optical disc at the reproduction time and sufficient CN ratio cannot be hence achieved. The weight average molecular weight M_{w} is generally of a value ranged within about 5000 to 10000.

As a photosensitive agent contained together with such base resin, there is proposed an ester reactant of, for example, an o-quinonediazido or naphthoquinonediazido and a polymer or monomer having a phenolic OH base (these are called as ballast compound). It is desired for the photosensitive agent to have an esterification ratio of more than 80%, and particularly, more than 90%. When the photosensitive agent having the esterification ratio of more than 80% is used, the uniformity of the exposure and development reactions can be further improved in the resist film formed by a photoresist containing such photosensitive agent together with the base resin having the molecular distribution M_{w} /Mₙ of less than 5.8. Accordingly, the thus produced optical disc original can provide more improved C/N ratio.

It is difficult to specifically determine the content ratio of the base resin and the photosensitive agent of the characters described above for the reason that the content ratio is different in combination of and the kinds of the base resin and the photosensitive agent. However, for example, in the photoresist in combination of the cresol novolak resin with a reactant obtained by ester-reacting a 1,2-naphthoquinonediazido-5-sulfonylchloride to nonbenzophenon ballast compound, it is desired that the reactant having 30 to 40, preferably more than 40, further preferably more than 60 weight parts is contained with respect to the cresol novolak resin of 100 weight parts.

The photoresist for the optical disc mentioned above is a light fusible type, i.e. positive type, photosensitive resin alkali fusible by the irradiation of light, and since, in the resist layer, the exposure and development reactions can uniformly progress, the pit shapes can be evenly formed in the optical disc original with small pit size and high recording density. Therefore, when such optical disc is reproduced, the noise level can be lowered and the improved CN ratio can be achieved.

In the drawings:-
In the accompanying drawings:

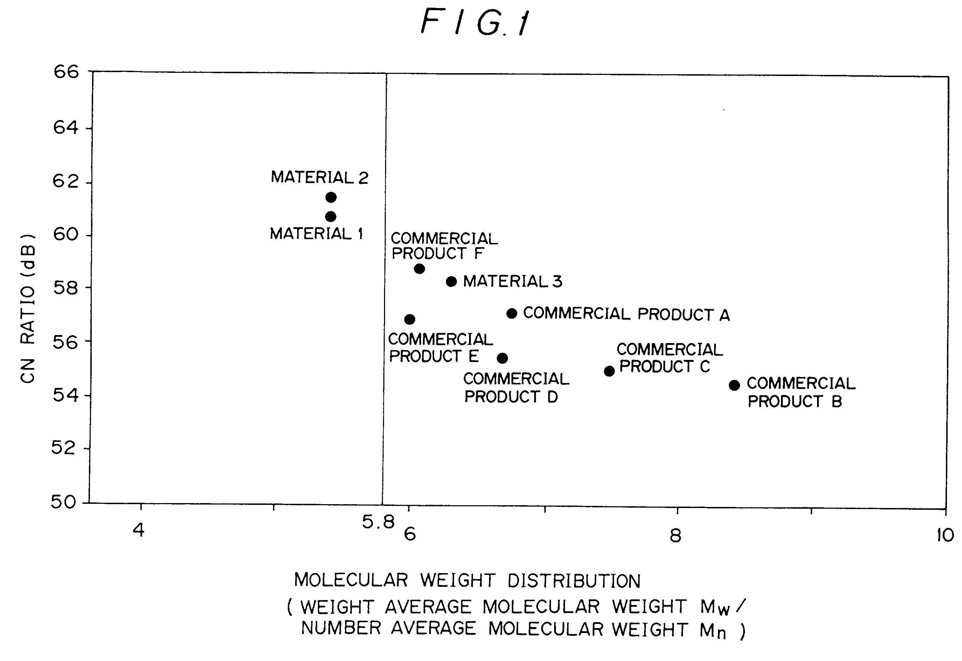

Fig. 1 is a graph showing a relationship between molecular weight distributions of the base resins in the photoresists utilized in experimental examples and comparative examples and CN ratios of optical disc originals formed by utilizing these photoresists; and
Figs. 2A to 2G show general steps in order for manufacturing an optical disc original.

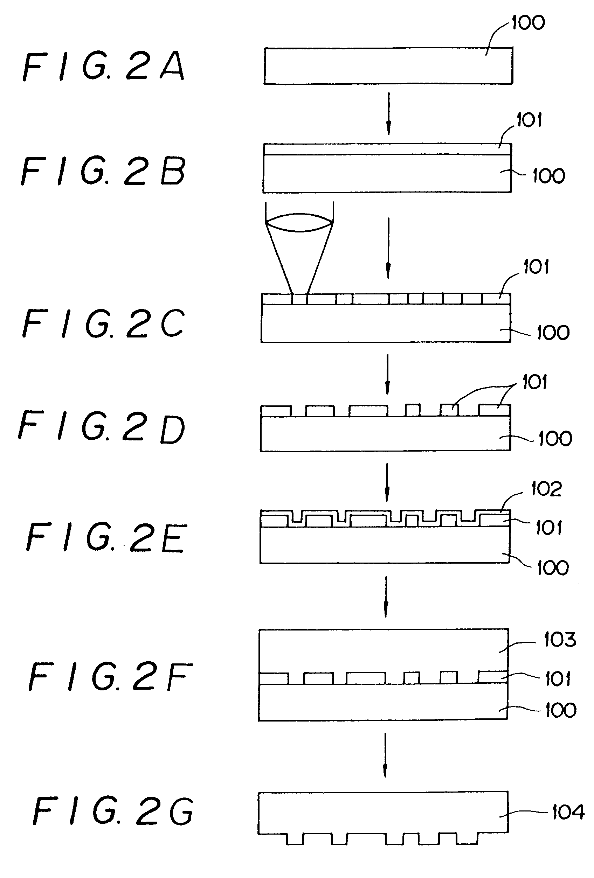

First, for a better understanding of this invention, general manufacturing steps of the optical disc will be described hereunder with reference to Fig. 2.

In a first step shown in Fig. 2A, a positive-type photoresist is coated with uniform thickness on a glass substrate 100 which was ground finely to thereby form a photoresist layer 101 as shown in Fig. 2B. In the next step of Fig. 2C, a laser beam is irradiated to a portion of the photoresist layer 101 at which a pit is formed. A portion of the photoresist layer 101 irradiated to the laser beam is easily dissolved in an alkali liquid developer in comparison with another portion not irradiated. Accordingly, when the development is performed by coating the alkali liquid developer on the photoresist layer 101, a recess corresponding to a pit is formed to the portion irradiated to the laser beam as shown in Fig. 2D. Thereafter, as shown in Fig. 2E, a metallic film 102 is formed on the photoresist layer 101 to which an electroconductivity is imparted, and in this step, For example, silver (Ag) or nickel (Ni) may be utilized as a metal for forming the metallic film. In the next step, as shown in Fig. 2F, an electrocasting treatment is performed to form an electrocast product, Ni electrocast 103, for example, on the metallic film 102. The nickel electrocast 103 is then peeled off from the glass substrate and the photoresist layer 101 together with the metallic film 102, the thus peeled off nickel electrocast and metallic film being called a metallic original, i.e. stamper 104 shown in Fig. 2G.

A preferred embodiment of the photoresist for the optical disc according to this invention will be next described hereunder with reference to experimental examples.

In the experiments, an optical disc was prepared generally in accordance with the method comprising the steps of coating a positive-type photoresist on a glass substrate to form a resist film, forming a pit pattern through a light exposure to the resist film, developing the resist film after the light exposure to form a resist original, effecting a plating treatment to the resist original to form a stamper by an electrocasting treatment, forming a replica disc through an injection molding process by utilizing the stamper, forming a reflection film on the replica disc, and forming an overcoat layer on the reflection film.

### Experimental Example 1

A material 1 was prepared by combining a cresol novolak resin as a base resin having a molecular weight distribution (weight average molecular weight M_{w} / number average molecular weight Mₙ) of a value of 5.4 with a reactant, as a photosensitive agent, obtained by ester-reacting the 1,2-naphthoquinonediazido-5-sulfonylchloride to a nonbenzophenon series ballast compound (esterification ratio of 80 to 90%), in which the reactant of 30 to 40 weight parts was combined with respect to the cresol novolak resin of 100 weight parts.

A pit pattern was then formed on a glass original having a thickness of 1.2mm by utilizing the thus prepared material 1, and thereafter, an aluminium film was directly diposited on the thus formed resist, and the CN ratio of the obtained optical disc original was measured. The measured result is shown in the following Table 1.

In the experiment, the constructions of the recording system and the reproduction system and the record reproduction conditions of signals were as follows.

Construction of Recording System:
λ = 351 nm; Numerical Aperture NA = 0.9
Construction of Reproduction System:
λ = 442 nm; Numerical Aperture NA = 0.5
Signal Recording:
f = 10MHz; Linear Speed = 6m/sec (CLV)
Signal Reproduction:
Linear Speed = 6m/sec; RBW = 30kHz

**TABLE 1**

| Resist | Average Molecular Weight (M_{w}/Mₙ) | CN ratio |
|---|---|---|
| Material 1 | 5:4 | 60.8 |
| Material 2 | 5.4 | 61.5 |
| Material 3 | 6.3 | 58.3 |
| Commercial Product A | 6.75 | 57.1 |
| Commercial Product B | 8.40 | 54.5 |
| Commercial Product C | 7.48 | 55.0 |
| Commercial Product D | 6.68 | 55.4 |
| Commercial Product E | 5.98 | 56.8 |
| Commercial Product F | 6.05 | 58.8 |

### Experimental Example 2

The material 2 was prepared by replacing the photosensitive agent in the material 1 with an ester reactant having an esterification ratio 100%. That is, the material 2 is substantially the same as the material 1 except for esterification ratio of the photosensitive agent.

A pit pattern was then formed on a glass original having a thickness of 1.2mm by utilizing the thus prepared material 2, and thereafter, an aluminium film was directly diposited on the thus formed resist, and the CM ratio of the obtained optical disc original showed a value higher than that of the material 1 by the amount of 0.7dB. The measured result is shown in the above Table 1.

### Comparative Experimental Example 1

The material 3 was prepared by replacing the base resin in the material 1 with a base resin having the molecular weight distribution M_{w}/Mₙ of 6.3. That is, the material 3 is substantially the same as the material 1 except for base resin utilized.

A pit pattern was then formed on a glass original having a thickness of 1.2mm by utilizing the thus prepared material 3, and thereafter, an aluminium film was directly diposited on the thus formed resist, and the CN ratio of the obtained optical disc original showed a value lower than that of the material 1 by the amount of 2.5dB. The measured result is shown in the above Table 1.

### Comparative Experimental Example 2

Six kinds of commercial products of photoresists A, B, C, D, E and F for manufacturing semiconductors were prepared and the molecular weight distributions M_{w}/Mₙ of these materials were measured.

Pit patterns were then formed on glass originals each having a thickness of 1.2mm by utilizing the thus prepared photoresists, and thereafter, aluminium films were directly diposited on the thus formed photoresists to form optical disc originals, and the CN ratios of the obtained optical disc originals were measured. The measured results are shown in the above Table 1.

### Consideration of Test Results

As can be seen from the Table 1, the CN ratios of the optical disc originals manufactured by utilizing the materials 1 and 2 were remarkably improved in comparison with the CN ratios of the optical disc originals manufactured by utilizing the material 3 and the respective commercial products A, B, C, D, E and F. According to this fact, it was found that the photoresist for the optical disc according to this invention has a high recording density even in small pit size. Furthermore, the relationship between the molecular weight distributions (weight average molecular weight M_{w} / number average molecular weight Mₙ)(horizontal axis) and the CN ratios (vertical axis) were protted in a coordinate system, and the obtained results are shown in the Table 1. As can be seen from the Table 1, it was found that the CN ratios are lowered as the molecular weight distributions of the base resins become large.

As described above, according to this invention, the exposure and developing reactions can uniformly progress in the resist film and the pits are evenly formed even in the small pit size. Accordingly, when an optical disc with high recording density having small pit size is manufactured by utilizing this photoresist, the noise level can be made small in the reproduction time and the improved CN ratio can be achieved.

## Claims

1. In a positive-type photoresist adapted for manufacturing an optical disc original comprising a photosensitive agent and a base resin, the improvement in which a molecular weight distribution (weight average molecular weight M_{w} / number average molecular weight Mₙ) in the base resin has a value less than 5.8.

2. A photoresist according to claim 1, wherein the molecular weight distribution has a value less than 5.0.

3. A photoresist according to claim 1, wherein the photosensitive agent has an esterification ratio of more than 80%.

4. A photoresist according to claim 3, wherein the esterification ratio is more than 90%.

5. A photoresist according to claim 1, wherein the base resin is composed of a cresol novolak resin and the photosensitive agent is a reactant formed by reacting a 1,2-naphthoquinonediazide-5-sulfonylchloride to a nonbenzophenon series ballast compound having 30 to 40 weight parts with respect to the cresol novolak resin of 100 weight parts.

6. A photoresist according to claim 5, wherein the weight parts of the 1,2-naphthoquinonediazido-5-sulfonylchloride is preferebly of more than 60 weight parts with respect to the cresol novolak resin of 100 weight parts.

7. A method of preparing an optical disc comprising the steps of:
preparing a positive-type photoresist composed of a base resin and a photosensitive material and also preparing a glass substrate (100);
coating the photoresist on the glass substrate (100) to form a resist film;
forming a pit pattern through a light exposure to the resist film;
developing the resist film after the light exposure to form a resist original;
effecting a plating treatment to the resist original to form a stamper (104);
forming a replica disc through an injection molding process by utilizing the stamper (104);
forming a reflection film on the replica disc; and
forming an overcoat layer on the refection film;
wherein the positive-type photoresist satisfies a condition that a molecular weight distribution (weight average molecular weight M_{w} / number average molecular weight Mₙ ) in the base resin has a value less than 5.8.

8. A method according to claim 7, wherein the molecular weight distribution has a value less than 5.0.

9. A method according to claim 7, wherein the photosensitive agent has an esterification ratio of more than 80 %.

10. A method according to claim 9, wherein the esterification ratio is more than 90 %.

11. A method according to claim 7, wherein the base resin is composed of a cresol novolak resin and the photosensitive agent is a reactant formed by reacting a 1,2-naphthoquinonediazido-5-sulfonylchloride to a nonbenzophenon series ballast compound having 30 to 40 weight parts with respect to the cresol novolak resin of 100 weight parts.

12. A method according to claim 7, wherein the weight parts of the 1,2-naphthoquinonediazido-5-sulfonylchloride is preferebly of more than 60 weight parts with respect to the cresol novolak resin of 100 weight parts.
